# FASCICULE DE BREVET EUROPEEN

(11) **EP 2 254 146 B1**
(45) Date de publication et mention de la délivrance du brevet: **10.03.2021**
(21) Numéro de dépôt: 10162587.9
(22) Date de dépôt: 11.05.2010
(51) Int. Cl.: H01L 29/06, H01L 29/165, H01L 29/775, H01L 21/20, B82Y 10/00

(54) **Structure semiconductrice et procédé de réalisation d'une structure semiconductrice**
Halbleiterstruktur und Herstellungsverfahren für eine Halbleiterstruktur
Semiconductor structure and method of manufacturing a semiconductor structure

(30) Priorité: 19.05.2009 FR 0953309
(43) Date de publication de la demande: 24.11.2010
(73) Titulaire: Commissariat à l'énergie atomique et aux énergies alternatives, 75015 Paris (FR)
(72) Inventeur: Pernel, Carole, 38120 St Egreve (FR); Dupre, Cécilia, 76240 Bonsecours (FR)
(74) Mandataire: Lebkiri, Alexandre

(56) Documents cités:
- WO-A1-2007/145407
- WO-A1-2008/106219
- FR-A1- 2 860 780
- US-A- 5 019 531
- US-A1- 2006 267 214

## Description

La présente invention concerne une structure semiconductrice ainsi qu'un procédé de réalisation de cette structure semiconductrice. L'invention trouve une application particulièrement intéressante dans le domaine de composants électroniques à base de nanofils de matériaux semiconducteurs (Si, Ge, SiGe, GaAs,...) ou à base de nanotubes, typiquement des nanotubes de carbone semiconducteur.

Au cours des dernières années, l'intérêt de la microélectronique pour les nano-objets, par exemple les nanofils semiconducteurs ou les nanotubes de carbone, dits NTC, a été très largement démontré.

C'est par exemple le cas des transistors à effet de champ possédant une structure de canal à nanofils semiconducteurs permettant d'améliorer deux facteurs normalement incompatibles : leur vitesse de fonctionnement et leur consommation.

Pour augmenter la vitesse de fonctionnement, on peut notamment réduire la taille des transistors ; toutefois, le fait de diminuer la taille des transistors implique par exemple le rapprochement de la source et du drain et la réalisation d'un canal de longueur de plus en plus faible. Cette tendance peut entraîner des effets néfastes au bon fonctionnement des transistors tels que des effets de canaux courts. Ainsi, à mesure que l'on diminue la longueur du canal des transistors, le drain et la source ont une influence de plus en plus importante sur la conduction du canal, normalement contrôlée par la grille. Les « effets de canaux courts » entraînent, entre autres, une diminution de la tension seuil avec la longueur de canal et la tension de drain, ce qui entraîne une augmentation de la fuite du transistor à l'état bloqué. Ceci n'est guère compatible avec l'amélioration des performances des circuits intégrés.

Une solution connue aux problèmes mentionnés ci-dessus consiste à proposer des transistors comportant un canal formé de plusieurs nanofils semiconducteurs permettant de diminuer les effets de canaux courts.

Un procédé connu pour former des nanofils semiconducteurs de silicium est la croissance par VLS-CVD (« Vapor-Liquid-Solid-Chemical-Vapor-Deposition »). Les premiers travaux concernant ce procédé ont débuté au cours des années 60. Le principe de cette technique consiste à déposer un grain d'or sur la surface d'un substrat puis à chauffer l'ensemble à une température voisine de 400°C. Les grains d'or préalablement déposés sur le substrat forment un mélange eutectique avec le Si à 343°C. Un flux de gaz, du SiCl₄ par exemple, permet la réduction du Si sur les gouttes du mélange Au-Si qui jouent leur rôle de catalyseur. Les gouttes du mélange Au-Si absorbent le Si qui précipite, entrainant la croissance des nanofils de Si. Depuis 2000, des travaux tels que la catalyse métallique MBE (« Molecular Beam Epitaxy ») et CBE (« Chemical Beam Epitaxy ») qui permettent un meilleur contrôle de la composition chimique, de la structure cristalline, des défauts et des états de dopage des nanofils sont venus compléter cette technique. Cependant, avec un tel type de procédé, la maîtrise du positionnement, de l'organisation et de la répartition des nanofils est très difficile à obtenir.

Une alternative à cette approche ascendante (ou « bottom-up » en anglais) et permettant de s'affranchir des problèmes précités consiste à utiliser une approche descendante ou « top-down » en anglais. Une telle approche est par exemple décrite dans l'article « Novel 3D integration process for highly scalable Nano-Beam stacked channels GAA (NBG) FinFETs with HfO2/TiN gate stack » (Ernst et al. - IEEE International Electron Devices Meeting IEDM, pp. 997-999, Technical Digest 2006). Ce procédé permet notamment d'obtenir des transistors à effet de champ multicanaux utilisant une matrice de nanofils de silicium répartis à la fois horizontalement et verticalement. Pour ce faire, la première étape consiste à faire croitre par épitaxie un super-réseau composé d'un empilement de couches minces sur un substrat du type semiconducteur sur isolant ou SOI (« Silicon On Insulator »). L'empilement est par exemple formé par une alternance de couches à base d'un premier matériau tel que du SiGe et de couches à base d'un deuxième matériau tel que du Si. La matrice de nanofils est ensuite obtenue par lithographie électronique puis par étapes successives de gravure anisotrope puis isotrope et sélective.

Ce procédé présente toutefois également certaines difficultés. En effet, la densité de nanofils obtenus est limitée par le « pitch », c'est-à-dire l'espacement entre deux fils dans la direction parallèle au wafer. Pour obtenir un espacement réduit, il est dès lors indispensable d'utiliser une lithographie électronique (ou lithographie « ebeam ») ou toute autre technique de lithographie avancée (telle que par exemple la lithographie Extreme Ultra Violet EUV) offrant une meilleure résolution qu'une photolithographie. Toutefois, il paraît difficile de continuer à diminuer la distance entre les nanofils à cause des effets de proximité (rétrodiffusion des électrons) dans le cas de la lithographie électronique. Cet espacement relativement important entre les nanofils rend difficile l'augmentation de la densité de courant délivrée pour une matrice de nanofils de taille fixée. Cette limitation présente donc un inconvénient majeur dans la mesure où l'intérêt des transistors à matrice de nanofils réside précisément dans le fait de rechercher une grande densité de nanofils afin d'obtenir de forte densité de courant permettant de palier la très faible densité de courant délivrée par un seul nanofil, notamment par rapport à un transistor planaire classique.

Ce problème d'espacement peut être résolu en utilisant des espaceurs afin de doubler ou même quadrupler les colonnes de fils ; une telle technique est notamment décrite dans l'article « Sub-20nm CMOS FinFET Technologies » (Choi et al. - IEDM Tech. Dig., p. 421, 2001). Néanmoins une telle technique implique des étapes supplémentaires compliquant considérablement le procédé.

Par ailleurs, aucune des approches descendantes décrites ci-dessus pour l'obtention de structure en trois dimensions ne permet d'intégrer des nanotubes tels que des nanotubes de Carbone, ces derniers étant obtenus uniquement par croissance. Un exemple d'intégration horizontale de nanotubes de carbone est décrit dans la demande de brevet WO2007/126412. Selon ce document, les NTC sont organisés dans le plan du substrat ; dès lors, cette technique ne permet pas d'obtenir des NTC en trois dimensions.

US 2006/0267214 A1 divulgue un empilement incluant une alternance de couches de GaAs et d'AlAs. Cet empilement possède un profil latéral dentelé. Les faces latérales des couches d'AlAs sont revêtues d'or.

Dans ce contexte, la présente invention a pour but de fournir une structure semiconductrice permettant de s'affranchir des problèmes précités et d'intégrer en trois dimensions des nanofils ou des nanotubes tels que des nanotubes de carbone selon une approche ascendante ou « bottom-up » et permettant d'obtenir une densité importante de nanofils ou de nanotubes.

A cette fin, l'invention propose une structure semiconductrice comportant soit les caractéristiques de la revendication 1, soit les caractéristiques de la revendication 2.

Grâce à l'invention, on obtient une nanostructure comportant au moins une face latérale verticale (par rapport au substrat horizontal) bi-matériaux. En d'autres termes, cette face latérale verticale est composée d'une alternance de bandes réalisées dans deux matériaux différents, typiquement un matériau semiconducteur (le premier matériau semiconducteur) tel que du Si et un matériau isolant (le troisième matériau) tel que par exemple du nitrure Si₃N₄. Cette alternance de bandes de matériaux différents permet de revêtir une série de bandes (par exemple les bandes de Si en tant que premier matériau) d'un matériau catalyseur pour la croissance de nanotubes ou de nanofils, par exemple sous la forme de grains (« nanodots » en anglais) d'or pour la croissance de nanofils de silicium. Ce revêtement catalytique est sélectif ; en d'autres termes, le matériau catalyseur revêt uniquement la première série de bandes réalisées dans le premier matériau et ne revêt pas les bandes réalisées dans le troisième matériau formant les bouchons. Le revêtement peut par exemple être obtenu par une fonctionnalisation de la surface de silicium ou par une siliciuration de la surface de silicium (i.e. formation de NiSi). Une telle structure permet de réaliser la croissance de nanofils ou de nanotubes sur plusieurs niveaux à partir de la surface latérale verticale.

On notera qu'il est également possible de réaliser le revêtement catalytique sélectif sur les bandes formées par les bouchons (par exemple des bouchons métalliques). Ces revêtements catalytiques peuvent alors être obtenus par dépôt électrolytique sur les bouchons métalliques.

De façon générale, la surface bi-matériaux permet de déposer le catalyseur uniquement sur les bandes à base d'un des deux matériaux puis de réaliser la croissance de nanofils ou de nanotubes à partir de la surface latérale verticale. La structure selon l'invention permet de réaliser la croissance de nanofils ou de nanotubes pour obtenir une matrice en s'affranchissant de l'étape de lithographie (cf. l'article « Novel 3D integration process for highly scalable Nano-Beam stacked channels GAA (NBG) FinFETs with HfO2/TiN gate stack » (Ernst et al. - IEEE International Electron Devices Meeting IEDM, pp. 997-999, Technical Digest 2006) précédemment cité). La structure permet ainsi d'intégrer des nanofils avec un espacement beaucoup plus réduit entre eux (typiquement 10 nm versus 80 nm pour des procédés utilisant la lithographie). Cette configuration permet donc d'augmenter la densité d'intégration de nanofils et donc la densité de courant délivrée par une matrice de taille fixée.

La structure selon l'invention peut également présenter une ou plusieurs des caractéristiques ci-dessous, considérées individuellement ou selon toutes les combinaisons techniquement possibles :
- le matériau est un matériau catalyseur pour la croissance de nanotubes ou de nanofils ;
- ledit matériau favorisant la croissance de nanotubes ou de nanofils revêt partiellement lesdites bandes latérales sous forme de grains ou « nanodots » espacés le long desdites bandes ;
- l'épaisseur desdites couches à base dudit premier matériau semiconducteur et/ou desdites couches à base dudit deuxième matériau semiconducteur est comprise entre 10 et 50 nm ;
- ledit premier matériau semiconducteur est le Si et ledit deuxième matériau semiconducteur est le SiGe ;
- lesdits bouchons sont réalisés dans un matériau isolant, ledit matériau favorisant la croissance de nanotubes ou de nanofils revêtant exclusivement les bandes latérales à base dudit premier matériau semiconducteur ;
- lesdits bouchons sont formés par une première partie réalisée dans un premier matériau diélectrique tel que du SiO₂ HTO « High Thermal Oxyde » et d'une deuxième partie réalisée dans un second matériau diélectrique tel qu'un nitrure de silicium du type Si₃N₄, ledit second matériau diélectrique correspondant au dit troisième matériau des bandes latérales ;
- ledit troisième matériau desdits bouchons est un métal, ledit matériau favorisant la croissance de nanotubes ou de nanofils revêtant exclusivement les bandes latérales à base dudit métal ;
- ledit support est un substrat comportant une couche semiconductrice tel qu'un substrat SOI (silicium sur isolant), Si ou Ge.

La présente invention a également pour objet un transistor intégrant une structure selon l'invention caractérisé en ce que ladite structure est dotée d'une pluralité de nanofils ou de nanotubes formant chacun un canal de transistor.

D'autres caractéristiques et avantages de l'invention ressortiront clairement de la description qui en est donnée ci-dessous, à titre indicatif et nullement limitatif, en référence aux figures annexées, parmi lesquelles :
- La figure 1 représente une structure semiconductrice selon un premier mode de réalisation de l'invention ;
- La figure 2 représente une vue de la face latérale d'un des blocs de la structure semiconductrice de la figure 1.
- Les figures 3a à 3i illustrent les différentes étapes d'un procédé de réalisation de la structure semiconductrice telle que représentée en figure 1.
- La figure 4 représente une structure semiconductrice selon un second mode de réalisation de l'invention ;
- La figure 5 représente une vue de la face latérale d'un des blocs de la structure semiconductrice de la figure 4.

Dans toutes les figures, les éléments communs portent les mêmes numéros de référence.

Nous ferons référence dans ce qui suit à un repère orthogonal [o, i, j, k] dans lequel le plan [o, i, k] définit le plan de la feuille et le vecteur j est perpendiculaire au plan de la feuille.

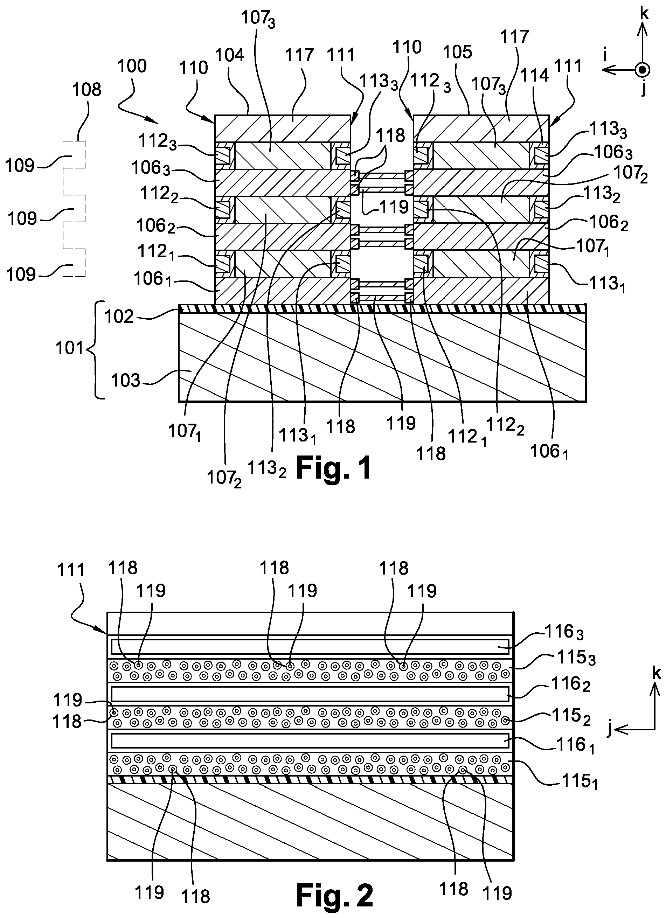

La figure 1 représente une structure semiconductrice 100 selon un premier mode de réalisation de l'invention.

La structure 100 comporte :
- un support 101 comprenant:
   ∘ une première couche semiconductrice 102, par exemple à base de silicium sur laquelle repose ;
   ∘ une couche isolante 103 telle qu'une couche d'oxyde enterré (« burried oxide » en anglais) à base de SiO₂ ;
- deux blocs semiconducteurs 104 et 105 espacés suivant la direction horizontale i.

Le plan [o, i, j] correspond au plan horizontal du support 101.

Chacun des deux blocs 104 et 105 a une structure identique et comporte un empilement de couches superposées suivant la direction verticale k. Cet empilement est formé d'une alternance de couches notées 106₁, 106₂ et 106₃ à base d'un premier matériau semiconducteur, tel que par exemple du Si, et de couches notées 107₁, 107₂ et 107₃ à base d'un second matériau semiconducteur différent du premier matériau semiconducteur, tel que par exemple du SiGe. Le second matériau est préférentiellement choisi pour pouvoir être gravé de manière sélective par rapport au premier matériau. Chacun des deux blocs 104 et 105 comporte par un ailleurs une couche supérieure 117 de masque dur, par exemple du Si₃N₄.

Les couches 106₁, 106₂ et 106₃ à base du premier matériau semiconducteur et les couches 107₁, 107₂ et 107₃ à base du second matériau semi-conducteur ont typiquement des épaisseurs suivant la direction k comprises entre 10 et 50 nm.

Les longueurs suivant la direction i des couches 106₁, 106₂ et 106₃ à base du premier matériau semiconducteur sont choisies supérieures aux longueurs des couches 107₁, 107₂ et 107₃ à base du second matériau semi-conducteur de sorte que l'alternance des couches 106₁, 106₂ et 106₃ et des couches 107₁, 107₂ et 107₃ ait un profil latéral dentelé ou en créneaux. Ce profil est illustré par les traits discontinus 108 sur la figure 1.

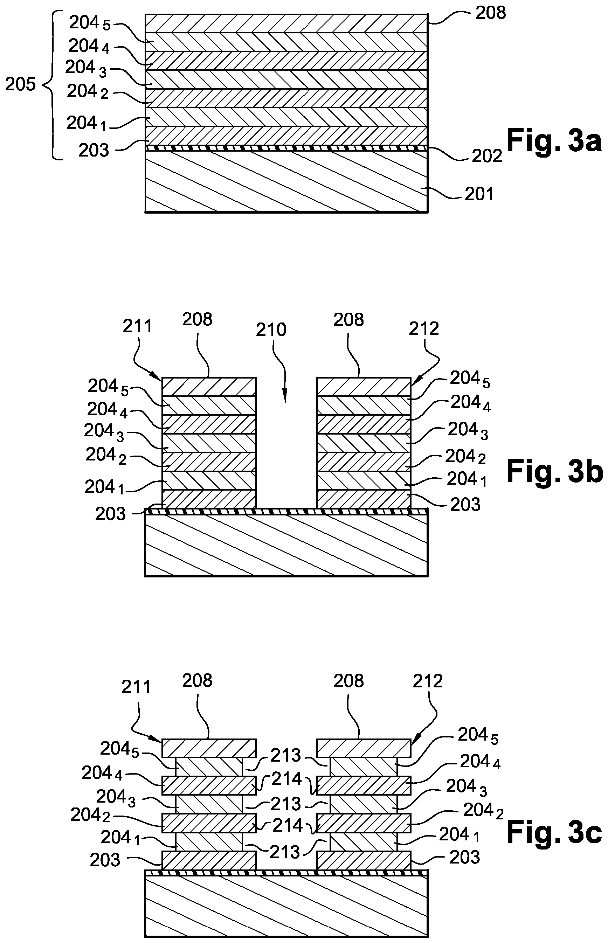

Il en résulte que chaque bloc 104 et 105 comporte sur chacune de ses deux faces latérales 110 et 111 un profil dentelé avec des « sillons » en SiGe et des parties saillantes en relief de Si. Chaque bloc 104 et 105 présente donc une topographie verticale organisée et dont on maîtrise les dimensions via l'épaisseur des couches de Si et de SiGe. Les espaces 109 formés par le profil dentelé 108 sont comblés totalement sur chacune des faces latérales 110 et 111 respectivement par des bouchons isolants ou espaceurs 112₁, 112₂ et 112₃ (face latérale 110) et par des bouchons isolants ou espaceurs 113₁, 113₂ et 113₃ (face latérale 111). Les bouchons sont ici réalisés sous la forme de barreaux sensiblement parallélépipédiques réalisés dans un matériau diélectrique tel qu'un nitrure de silicium du type Si₃N₄. Pour des raisons technologiques liés au procédé de fabrication que nous expliciterons par la suite en référence aux figures 3a à 3i, les bouchons peuvent également être enveloppé partiellement d'une couche 114 réalisée dans un autre matériau diélectrique tel que du SiO₂ de type HTO.

La figure 2 représente une vue suivant le plan [O, j, k] de la face latérale 111 du bloc 104. Cette face 111 comporte une alternance de bandes notées 115₁, 115₂ et 115₃ à base du premier matériau semiconducteur (typiquement du Si) et de bandes notées 116₁, 116₂ et 116₃ à base du matériau diélectrique tel qu'un nitrure de silicium du type Si₃N₄.

Les bandes 115₁, 115₂ et 115₃ à base du premier matériau semiconducteur sont revêtues d'un matériau catalyseur apte à faciliter la croissance de nanotubes (typiquement des nanotubes de carbone NTC) ou de nanofils (typiquement des nanofils semiconducteurs tels que des nanofils de Si). Ce revêtement prend la forme de grains 118 (ou « nanodots » selon la terminologie anglo-saxonne). On peut par exemple utiliser des grains d'Au (revêtant les bandes 115₁, 115₂ et 115₃ à base de Si) qui constitue un excellent catalyseur pour la croissance de nanofils de Si. Comme nous le verrons par la suite lors de la description du procédé d'obtention de la structure 100, ce revêtement de nanodots 118 peut être par exemple obtenu par une fonctionnalisation de la surface de Si. On notera que le fait d'avoir deux matériaux différents pour les deux types de bandes 115₁, 115₂ et 115₃ (en Si) et 116₁, 116₂ et 116₃ (isolantes) permet de revêtir sélectivement les bandes 115₁, 115₂ et 115₃ du matériau catalyseur sans revêtir les bandes 116₁, 116₂ et 116₃.

On utilise ensuite ces grains 118 pour effectuer une croissance horizontale de nanofils 119 dans la structure confinée existant entre la surface latérale 111 du bloc 104 et la surface latérale 110 du bloc 105. On notera que, grâce à la structure selon l'invention, il est non seulement possible de d'obtenir un empilement vertical (suivant la direction k) de nanofils mais également une répartition horizontale (suivant la direction j) de nanofils de sorte que l'on obtient une organisation en trois dimensions de nanofils. La structure permet donc notamment d'obtenir une structure multicanaux utilisant une matrice de nanofils de silicium répartis à la fois horizontalement et verticalement pour la réalisation de transistors à effet de champ multicanaux.

La structure 100 selon l'invention permet tout d'abord de déposer les catalyseurs ou précurseurs à la croissance de nanofils/nanotubes sur les surfaces latérales verticales bi-matériaux puis de réaliser la croissance des nanofils/nanotubes dans l'espace confiné existant les surfaces latérales 111 et 110 des deux blocs 104 et 105.

Le mode de réalisation décrit ci-dessus concernait plus spécifiquement la réalisation de nanofils de Si mais la structure selon l'invention permet plus généralement de réaliser un empilement de nanofils à base d'autres matériaux semiconducteurs (typiquement Ge, SiGe, GaAs) ou métalliques mais aussi de nanotubes (Graphène, Si).

La structure 100 selon l'invention décrite ci-dessus trouve une application particulièrement intéressante dans le cadre de la réalisation de transistor à multicanaux, un nanofil étant un canal du transistor. A partir de la structure 100 représentée en figure 1, il est ainsi possible de réaliser un oxyde grille autour de chaque nanofil 119 ; cet oxyde de grille peut par exemple être obtenu par oxydation du silicium des nanofils 119 ou par dépôt d'une couche de diélectrique (HfO2 par exemple). L'épaisseur de la couche d'oxyde est typiquement au moins égale à 2nm. On peut ensuite réaliser une grille enrobante comblant le volume existant entre les oxydes de grille des nanofils 119. Le dépôt de cette grille enrobante peut par exemple être obtenu par le dépôt de polysilicium dopé ou d'un mélange de métal et de polysilicium dopé. Le procédé de dépôt de la grille est par exemple un procédé de type CVD (« Chemical Vapor Déposition » en anglais) de façon à obtenir un dépôt conforme qui enrobe l'ensemble des nanofils 119.

Les figures 3a à 3i illustrent les différentes étapes d'un procédé de réalisation de la structure semiconductrice 100 telle que représentée en figure 1.

La première étape de ce procédé illustrée sur la figure 3a, consiste à réaliser un empilement de couches minces sur un substrat, qui peut être de type semi-conducteur sur isolant, et comprendre une première couche semi-conductrice 201, par exemple à base de silicium, sur laquelle repose une couche isolante 202 par exemple une couche d'oxyde enterré (burried oxide selon la terminologie anglo-saxonne) à base de SiO₂, elle-même recouverte d'une deuxième couche semi- conductrice 203. Cette deuxième couche semi-conductrice 203 est ici à base d'un premier matériau semiconducteur tel que du Si.

On réalise ensuite un empilement 205 formé d'une alternance de couches notées 203, 204₂ et 204₄ à base du premier matériau semiconducteur Si, et de couches notées 204₁, 204₃ et 204₅ à base d'un deuxième matériau différent du premier matériau tel que du SiGe. Le deuxième matériau est un matériau susceptible de pouvoir être gravé de manière sélective vis-à-vis du premier matériau.

Les couches 204₁,..., 204₅ sont des couches semi-conductrices formées par exemple, par plusieurs épitaxies successives à partir de la deuxième couche semi-conductrice 203.

Une fois l'empilement 205 réalisé, on effectue le dépôt d'une couche de masque dur 208, par exemple à base d'un matériau diélectrique tel que du Si₃N₄, ou à base d'un autre matériau apte à protéger l'empilement 205 d'une gravure telle que, par exemple, une gravure plasma. Ensuite, on dépose une couche de résine photosensible non représentée, par exemple à base de polyimide, sur la couche de masque dur 208, et l'on définit dans la couche de résine, par exemple par une méthode de photolithographie (dite lithographie « deep UV »), un masque de résine comportant au moins un motif pour la réalisation d'une tranchée. On notera que le procédé selon l'invention utilise une méthode de lithographie standard et qu'il n'est pas nécessaire d'utiliser une lithographie électronique offrant une meilleure résolution.

On effectue ensuite (figure 3b) une gravure anisotrope de la couche 208 de masque dur, par exemple une gravure plasma à base de CH₂F₂ + He0₂ + CF₄.

On procède ensuite à une étape de gravure des couches 203, 204₁,..., 204₅, situées sous le masque dur 208, afin de reproduire le motif de ce dernier dans l'empilement 205. La gravure est de type anisotrope, et réalisée par exemple à l'aide d'un plasma à base de HBr + Cl + HeO₂.

La figure 3b représente la tranchée 210 obtenue après la gravure anisotrope de l'empilement 205 séparant deux empilements 211 et 212 comportant chacun une alternance de couches 203, 204₁,..., 204₅, en Si et en SiGe.

On effectue alors (figure 3c) une seconde gravure de chacun des empilements 211 et 212. Cette seconde gravure est isotrope et sélective, de manière à retirer partiellement certaines des couches 203, 204₁,..., 204₅ des empilements 211 et 212. Dans le cas présent, on retire par exemple les couches 204₁, 204₃ et 204₅ à base du deuxième matériau (SiGe). La gravure est donc ici une gravure isotrope du deuxième matériau semi-conducteur SiGe, sélective vis-à-vis du premier matériau semi-conducteur Si. Une telle gravure peut être réalisée par exemple à l'aide d'un plasma à base de CF₄ +O₂. Les empilements 211 et 212 étant protégés sur le dessus par le masque dur 208, la seconde gravure permet d'effectuer un retrait de portions des couches 204₁, 204₃.et 204₅ à base du deuxième matériau (SiGe), de part et d'autre de chacun des empilements 211 et 212, au niveau des flancs ou faces latérales de ces derniers (figure 3c). Les couches 203, 204₂ et 204₄ à base du premier matériau semiconducteur Si ont une étendue supérieure à celle des couches 204₁, 204₃ et 204₅ à base du deuxième matériau semiconducteur SiGe.

Il résulte, à la suite de la seconde étape de gravure, que chacun des empilements 211 et 212 comporte sur ses flancs, ou sur chacune de ses faces latérales, un profil dentelé formé par des « sillons » 213 à base du deuxième matériau semiconducteur SiGe et de parties saillantes 214 à base du premier matériau semiconducteur Si.

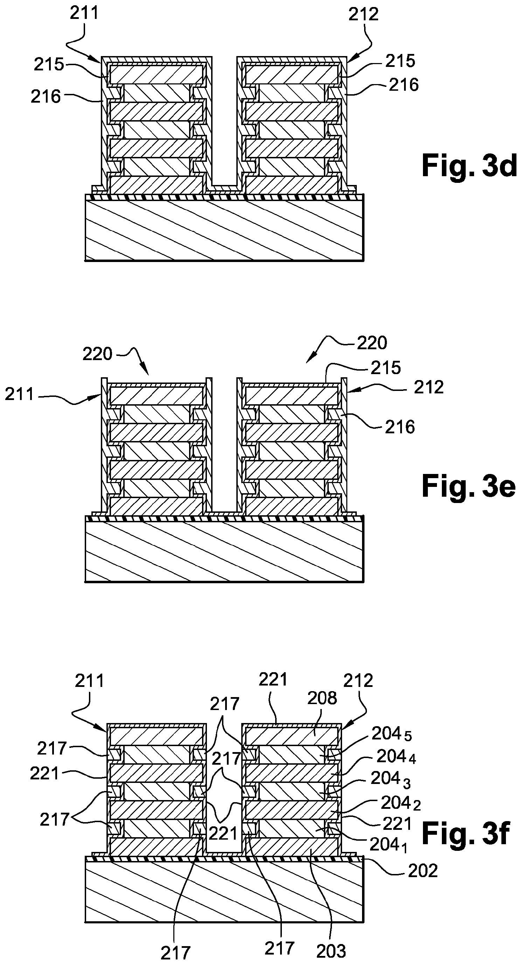

L'étape suivante illustrée en figure 3d consiste à réaliser un dépôt conforme d'un premier matériau diélectrique 215, par exemple du SiO₂ de type HTO (« High Thermal Oxyde » en anglais) recouvrant la périphérie des empilements 211 et 212 et servant de protection (couche d'arrêt) des empilements 211 et 212 lors s'une étape ultérieure de gravure.

Conformément à cette même figure 3d, on réalise ensuite un autre dépôt d'un second matériau diélectrique 216, par exemple du Si₃N₄, de manière à recouvrir les empilements 211 et 212 et combler les « sillons » 213 à base du deuxième matériau semiconducteur SiGe.

On retire ensuite le second matériau diélectrique 216 de manière à conserver ce matériau uniquement dans les « sillons » 213 à base du deuxième matériau semiconducteur SiGe.

Ce retrait est effectué via une première gravure anisotrope (figure 3e) du second matériau diélectrique 216 Si₃N₄, sélective vis-à-vis du premier matériau diélectrique 215 HTO, par exemple au moyen d'une gravure plasma CF₄ + HBr. Cette première gravure permet de retirer la partie supérieure 220 du second matériau diélectrique 216 Si₃N₄ mais également de retirer ce second matériau 216 sur les surfaces horizontales aux pieds des structures 211 et 212.

Puis (figure 3f), on réalise une gravure isotrope du second matériau diélectrique 216 Si₃N₄, sélective vis-à-vis du premier matériau diélectrique 215 HTO, par exemple au moyen d'une gravure plasma SF₆ + HBr. Cette gravure est réalisée de façon à retirer partiellement le second matériau diélectrique 216 Si₃N₄, uniquement sur les parties latérales 221 des empilements 211 et 212. On forme ainsi des bouchons ou espaceurs 217 comblant les espaces formés par les « sillons » 213 à base du deuxième matériau semiconducteur SiGe. La gravure isotrope est telle que, après formation des bouchons 217, chacun des empilements 211 et 212 comporte sur ses faces latérales une nouvelle surface plane ou sensiblement plane.

L'étape illustrée en figure 3f permet donc de réaliser des bouchons isolants 217 à base de Si₃N₄ et de HTO ; on créée ainsi, sur les surfaces latérales planes des empilements 211 et 212, une alternance de bandes isolantes (Si₃N₄ + HTO) et de bandes semiconductrices (Si).

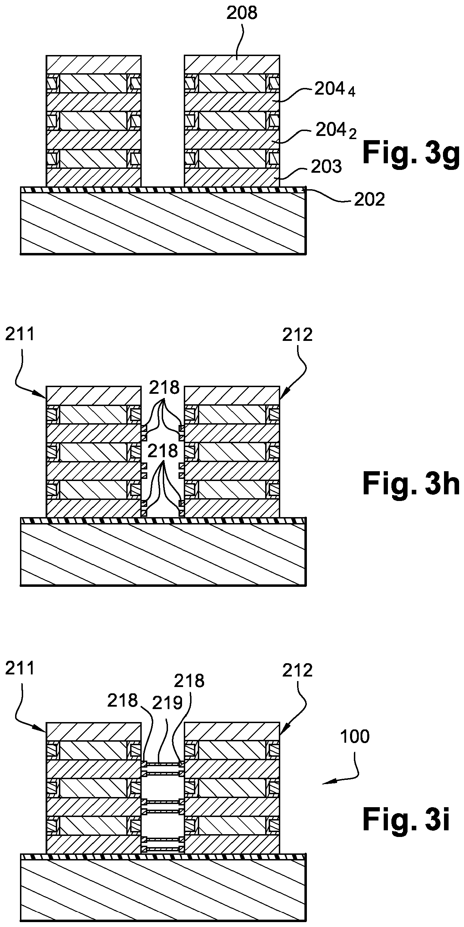

Conformément à la figure 3g, on retire le reste du premier matériau diélectrique 215 HTO encore présent sur la couche 202, sur les flancs des couches 203, 204₂ et 204₄ à base du premier matériau semiconducteur Si et sur la partie supérieure de la couche 208. Ce retrait peut être obtenu par exemple par un nettoyage HF.

L'étape illustrée en figure 3h va consister à utiliser avantageusement la sélectivité réactionnelle de la structure bi matériaux Si d'une part et HTO/nitrure d'autre part, le Si étant semi-conducteur et le HTO/nitrure étant isolant, pour déposer sélectivement un catalyseur apte à favoriser la croissance de nanofils sur le silicium et non sur le HTO/nitrure. Ce dépôt est ici réalisé grâce à une fonctionnalisation des surfaces de silicium ; on entend par fonctionnalisation l'action d'attacher ou de greffer une ou des molécules chimiques sur les bandes latérales de silicium. Cette fonctionnalisation a pour but de conférer des propriétés particulières aux bandes de Si (en l'espèce favoriser la croissance ultérieure de nanofils/nanotubes).

La fonctionnalisation consiste en la réalisation d'un pavage des bandes de Si par des grains ou nanodots 218 (par exemple d'Au) sans recouvrir les bandes HTO/nitrure.

Dans la pratique, une fine couche de SiO₂ natif (d'une épaisseur de l'ordre de 1 nm) se forme le plus souvent sur la couche de Si et il convient donc de réaliser le revêtement d'Au sur du SiO₂.

La fonctionnalisation (ou modification des propriétés chimiques superficielles) des bandes de SiO₂ natif consiste à déposer des films auto-organisés ou SAMs (« Self-Assembled Monolayers » en anglais). Ce type de fonctionnalisation est notamment décrit dans le document « Self assembled monolayers on silicon for molecular electronics » (Aswal et al, Analytica chimica acta 2005). Les molécules utilisées pour former les SAMs sont généralement constituées d'un groupement de surface hydrophobe et d'un groupement d'accroche hydrophile tous deux reliés par une chaîne alkyle. Les chaînes tendent à s'arranger perpendiculairement à la surface formant une structure dense et organisée principalement grâce aux interactions de Van der Waals présentes entre les chaînes hydrophobes.

La surface de Si recouverte de sa couche d'oxyde natif est tout d'abord nettoyée (par exemple via un nettoyage chimique du type RCA) afin de créer en surface des groupements -OH qui vont permettre l'obtention d'un bon greffage. La présence de ces groupements hydroxyles rend la surface très hydrophile entraînant le piégeage naturel d'une fine pellicule d'eau

On met ensuite en présence des bandes nettoyées des molécules de silane (typiquement du trichlorosilane RSiCl₃ où R est une chaîne alkyle terminée par un groupement de surface hydrophobe) qui vont spontanément venir positionner leurs groupements d'accroche hydrophiles (Si-Cl₃) vers la couche d'eau alors que la tête de la chaîne alkyle (hydrophobe) va avoir tendance à s'en éloigner.

La couche d'eau hydrolyse les groupements Si-Cl₃ pour former une tête trihydrosiloxane Si-(OH)₃.

La présence d'une fine couche de liquide permet une mobilité planaire des molécules qui se rapprochent alors les unes des autres, ce qui tend à favoriser la réaction de condensation entre molécules voisines ; des liaisons Si-O-Si se créent entre les molécules formant ainsi une couche moléculaire à deux dimensions. La même réaction de réticulation se produit entre le substrat et le film formé. Une monocouche de silane greffée de façon covalente est donc obtenue sur la surface de SiO₂.

On peut alors fixer au bout des groupements alkyles, des groupements tels que des thiols (par exemple SH). Ce groupement thiol est très réactif avec l'Au de sorte qu'en déposant de l'or sur la surface déjà traitée, on obtient des liaisons covalentes Or-Souffre.

Le dépôt d'or se fait sélectivement sur les bandes de SiO₂ natif et non sur les bandes de HTO/nitrure (pas de création en surface des groupements -OH). En choisissant la concentration en Au adaptée, on peut réaliser un dépôt discret de nanodots d'Au sur les bandes semiconductrices et réaliser ainsi un pavage des bandes de Si par des grains ou nanodots 218. L'article « Electroless deposition and electrical resistivity of sub-100 nm Cu films on SAMs : State of the art » (Glickman at al - Microelectronic Engineering 84 (2007) 2466-2470) décrit différents exemples de réalisation de dépôt métallique sur les SAMs, le dépôt se faisant généralement sous la forme d'ilots discrets. Le dépôt de métal sur les SAMs peut être obtenu par différentes techniques telles que des procédés à oxydoréduction sans apport de courant du type electroless, des procédés d'électrodéposition ou des procédés de dépôt de particules colloïdales.

La description faite ci-dessus concerne la fonctionnalisation de l'oxyde natif mais il est également possible de fonctionnaliser directement les bandes de Si sans passer par la formation des couches de SiO₂ natif.

De même, il est possible de greffer d'autres métaux que l'Au ; on peut par exemple envisager de greffer des métaux tels que le Ni, Co, Pt, Pd, Rh, Ru, Fe, Al, Ag ou le Cu.

L'étape de fonctionnalisation telle que représentée en figure 3h peut être remplacée par une étape de siliciuration ; on créé ainsi sur les bandes latérales de Si un revêtement du type NiSi ou PtSi. L'emploi de siliciures métalliques est connu pour réduire les résistances de contact des parties actives des transistors. La formation d'ilots de siliciure est un phénomène connu de l'homme du métier. La siliciuration est utilisée ici pour la réalisation d'un revêtement catalytique métallique NiSi ou PtSi aptes à favoriser la croissance de nanotubes ou de nanofils. Pour ce faire, on commence par déposer une couche métallique de Ni ou de Pt puis on effectue un recuit qui permet d'obtenir un alliage NiSi ou PtSi.

On retire ensuite par nettoyage chimique le Ni ou le Pt restant (i.e. n'ayant pas réagi avec le Si) ainsi que le Ni ou le Pt déposé sur les bandes isolantes HTO/nitrure.

Le revêtement de grains métalliques 218 peut être également obtenu par un dépôt électrochimique du métal sur les bandes de Si.

L'étape illustrée en figure 3i consiste ensuite à réaliser la croissance de nanofils (typiquement des nanofils de Si) 219 reliant deux nanodots 218 situés respectivement sur les surfaces latérales planes de Si des empilements 211 et 212. Pour clarifier l'illustration, la figure 3i représente des nanofils 219 reliant chacun deux nanodots 218 en regard l'un de l'autre ; la croissance étant aléatoire, il convient toutefois de noter que la probabilité pour qu'un nanofil relie deux nanodots en regard l'un de l'autre est relativement faible. Généralement, la croissance des nanofils permettra donc de relier les deux blocs 211 et 212 mais les nanofils ne joindront pas forcément deux nanodots en vis-à-vis et ne seront pas forcément parfaitement parallèle au substrat. Une solution pour obtenir des nanofils parallèles peut constituer à utiliser un axe cristallographique de croissance privilégié par les nanofils. Cette croissance peut être réalisée par un procédé VLS-CVD (« Vapor-Liquid-Solid-Chemical-Vapor-Deposition ») ou par toute autre procédé permettant la croissance de nanofils. On aboutit alors à une structure 100 identique à la structure représentée en figure 1 (les grains 118 de la figure 1 correspondant aux grains 218 de la figure 3i et les nanofils 119 de la figure 1 correspondant aux nanofils 219 de la figure 3i).

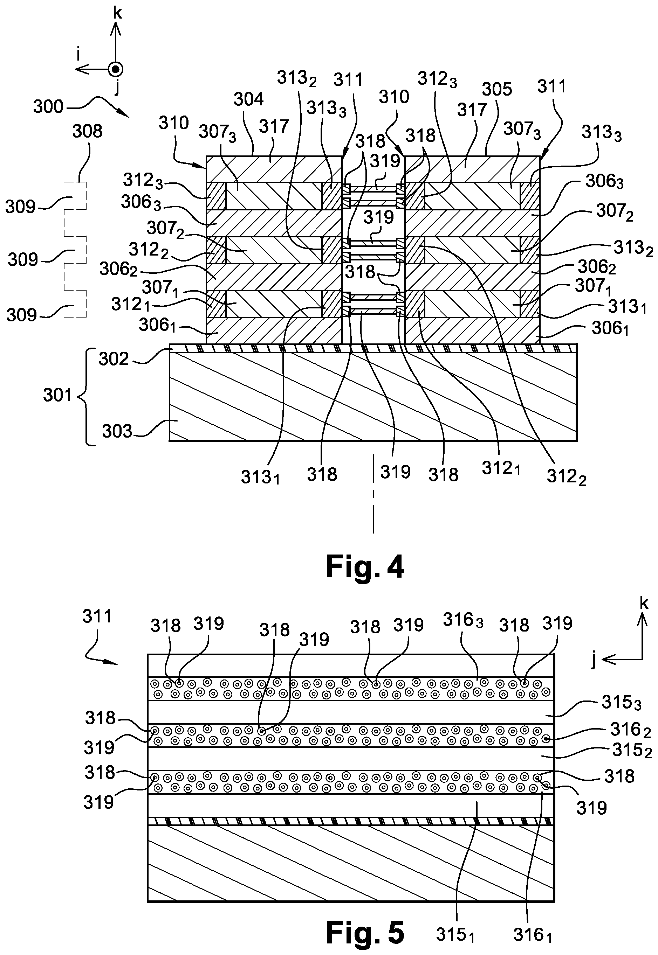

La figure 4 représente une structure semiconductrice 300 selon un second mode de réalisation de l'invention.

La structure 300 comporte :
- un support 301 comprenant:
   ∘ une première couche semiconductrice 303, par exemple à base de silicium sur laquelle repose ;
   ∘ une couche isolante 302 telle qu'une couche d'oxyde enterré (BOX ou « burried oxide » en anglais) à base de SiO₂ ;
- deux blocs semiconducteurs 304 et 305 espacés suivant la direction horizontale i.

Le plan [o, i, j] correspond au plan horizontal du support 301.

Chacun des deux blocs 304 et 305 a une structure identique et comporte un empilement de couches superposées suivant la direction verticale k. Cet empilement est formé d'une alternance de couches notées 306₁, 306₂ et 306₃ à base d'un premier matériau semiconducteur, tel que par exemple du Si, et de couches notées 307₁, 307₂ et 307₃ à base d'un second matériau semiconducteur différent du premier matériau semiconducteur, tel que par exemple du SiGe. Le second matériau est préférentiellement choisi pour pouvoir être gravé de manière sélective par rapport au premier matériau.

Chacun des deux blocs 304 et 305 comporte par un ailleurs une couche supérieure 317 de masque dur, par exemple du Si₃N₄.

Les couches 306₁, 306₂ et 306₃ à base du premier matériau semiconducteur et les couches 307₁, 307₂ et 307₃ à base du second matériau semi-conducteur ont typiquement des épaisseurs suivant la direction k comprises entre 10 et 50 nm.

Les longueurs suivant la direction i des couches 306₁, 306₂ et 306₃ à base du premier matériau semiconducteur sont choisies supérieures aux longueurs des couches 307₁, 307₂ et 307₃ à base du second matériau semi-conducteur de sorte que l'alternance des couches 306₁, 306₂ et 306₃ et des couches 307₁, 307₂ et 307₃ ait un profil latéral dentelé ou en créneaux. Ce profil est illustré par les traits discontinus 308 sur la figure 4.

Il en résulte que chaque bloc 304 et 305 comporte sur chacune de ses deux faces latérales 310 et 311 un profil dentelé avec des « sillons » en SiGe et des parties saillantes en relief de Si. Chaque bloc 304 et 305 présente donc une topographie verticale organisée et dont on maîtrise les dimensions via l'épaisseur des couches de Si et de SiGe. Les espaces 309 formés par le profil dentelé 308 sont comblés totalement sur chacune des faces latérales 310 et 311 respectivement par des bouchons métalliques ou espaceurs métalliques 312₁, 312₂ et 312₃ (face latérale 310) et par des bouchons métalliques ou espaceurs métalliques 313₁, 313₂ et 313₃ (face latérale 311). Les bouchons sont ici réalisés sous la forme de barreaux sensiblement parallélépipédiques réalisés dans un matériau métallique tel que le Co, le Ni ou le Cu.

La figure 5 représente une vue suivant le plan [O, j, k] de la face latérale 311 du bloc 304. Cette face 311 comporte une alternance de bandes notées 315₁, 315₂ et 315₃ à base du premier matériau semiconducteur (typiquement du Si) et de bandes notées 316₁, 316₂ et 316₃ à base du matériau métallique.

Les bandes 316₁, 316₂ et 316₃ à base du matériau métallique sont revêtues d'un matériau métallique catalyseur apte à faciliter la croissance de nanotubes ou de nanofils. Ce revêtement prend la forme de grains métalliques 318. On peut par exemple utiliser des grains d'Au qui constitue un excellent catalyseur pour la croissance de nanofils de Si ou des grains de Ni ou de Fe pour la croissance de nanotubes de carbone. Ce revêtement de grains métalliques 318 peut être par exemple obtenu par un dépôt électrolytique du métal sur les bandes métalliques. On notera que le fait d'avoir deux matériaux différents pour les deux types de bandes 315₁, 315₂ et 315₃ (en Si) et 316₁, 316₂ et 316₃ (métalliques et donc meilleurs conducteurs que le Si) permet de revêtir sélectivement les bandes 316₁, 316₂ et 316₃ du matériau catalyseur par dépôt électrolytique sans revêtir les bandes 315₁, 315₂ et 315₃.

On utilise ensuite ces grains 318 pour effectuer une croissance horizontale de nanofils 319 dans la structure confinée existant entre la surface latérale 311 du bloc 304 et la surface latérale 310 du bloc 305.

La couche isolante BOX 302 permet de mieux isoler les nanofils 319 du substrat formé par la première couche semiconductrice 303.

Des grains d'Au peuvent également être utilisés pour bloquer la croissance de nanotubes de carbone ; selon ce mode de réalisation, les grains d'Au n'agissent pas comme catalyseur et les nanotubes de carbone vont préférentiellement croitre sur les bandes 315₁, 315₂ et 315₃ (en Si) non recouvertes d'Au. Un tel procédé de croissance est par exemple décrit dans la demande de brevet WO2006010684.

Bien entendu, le dispositif et le procédé selon l'invention ne sont pas limités aux modes de réalisation qui viennent d'être décrits à titre indicatif et nullement limitatif en référence aux figures 1 à 5.

Notamment, même si l'invention a été plus particulièrement décrite dans le cas d'une structure avec deux blocs nano-structurés, il est également possible d'avoir un seul bloc bi-matériaux avec des nanofils ou des nanotubes formés à partir des bandes latérales de ce bloc, l'ensemble des nanofils ou nanotubes étant reliés ensemble à un même bloc formé d'un seul matériau.

## Revendications

1. Structure semiconductrice (100, 300) comportant :
- un support (101, 301);
- un premier bloc (104, 304) reposant sur ledit support, comportant :
∘ un empilement incluant une alternance de couches (106₁, 106₂, 106₃, 306₁, 306₂, 306₃) à base d'un premier matériau semiconducteur et de couches (107₁, 107₂, 107₃, 307₁, 307₂, 307₃) à base d'un deuxième matériau semiconducteur différent dudit premier matériau semiconducteur, lesdites couches (106₁, 106₂, 106₃, 306₁, 306₂, 306₃) à base dudit premier matériau semiconducteur présentant des dimensions supérieures aux couches (107₁, 107₂, 107₃, 307₁, 307₂, 307₃) à base dudit deuxième matériau semiconducteur de sorte que ledit empilement possède un profil latéral dentelé (108, 308);
∘ une pluralité de bouchons (112₁, 112₂, 112₃, 113₁, 113₂, 113₃, 312₁, 312₂, 312₃, 313₁, 313₂, 313₃) comblant les espaces formés par ledit profil dentelé (108) de sorte que ledit empilement présente une surface latérale sensiblement plane, lesdits bouchons (112₁, 112₂, 112₃, 113₁, 113₂, 113₃, 312₁, 312₂, 312₃, 313₁, 313₂, 313₃) étant réalisés dans un troisième matériau différent dudit premier matériau semiconducteur de sorte que chacune des faces latérales (110, 111, 310, 311) dudit bloc (104, 105, 304, 305) présente une alternance de bandes latérales (115₁, 115₂, 115₃ , 315₁, 315₂, 315₃) à base dudit premier matériau et de bandes latérales (116₁, 116₂, 116₃ , 316₁, 316₂, 316₃) à base dudit troisième matériau, au moins une des faces latérales (110, 111, 310, 311) dudit premier bloc étant revêtue partiellement d'un matériau (118, 318) favorisant la croissance de nanotubes ou de nanofils (119, 319) exclusivement sur les bandes latérales à base dudit premier matériau semiconducteur (115₁, 115₂, 115₃) ou exclusivement sur les bandes latérales à base dudit troisième matériau (316₁, 316₂, 316₃), ledit matériau favorisant la croissance de nanotubes ou de nanofils (119, 319) revêtant exclusivement les bandes latérales (115₁, 115₂, 115₃) à base dudit premier matériau semiconducteur ou exclusivement les bandes latérales à base dudit troisième matériau (316₁, 316₂, 316₃) ; ladite structure comportant un deuxième bloc (105, 305) reposant sur ledit support, le premier et le deuxième bloc se faisant face et étant connectés par une pluralité de nanofils ou de nanotubes (119, 319), chacun desdits nanofils ou desdits nanotubes (119, 319) reliant une bande latérale du premier bloc (104, 304) revêtue du matériau favorisant la croissance de nanotubes ou de nanofils à une partie du deuxième bloc (105, 305) étant en regard de la bande latérale dudit premier bloc revêtue du matériau favorisant la croissance de nanotubes ou de nanofils, ledit deuxième bloc étant formé d'un seul matériau.

2. Structure semiconductrice (100, 300) comportant :
- un support (101, 301);
- un premier bloc (104, 304) et un deuxième bloc (105, 305) reposant sur ledit support, chacun desdits premier et deuxième blocs comportant :
∘ un empilement incluant une alternance de couches (106₁, 106₂, 106₃, 306₁, 306₂, 306₃) à base d'un premier matériau semiconducteur et de couches (107₁, 107₂, 107₃, 307₁, 307₂, 307₃) à base d'un deuxième matériau semiconducteur différent dudit premier matériau semiconducteur, lesdites couches (106₁, 106₂, 106₃, 306₁, 306₂, 306₃) à base dudit premier matériau semiconducteur présentant des dimensions supérieures aux couches (107₁, 107₂, 107₃, 307₁, 307₂, 307₃) à base dudit deuxième matériau semiconducteur de sorte que ledit empilement possède un profil latéral dentelé (108, 308);
∘ une pluralité de bouchons (112₁, 112₂, 112₃ ,113₁, 113₂, 113₃, 312₁, 312₂, 312₃, 313₁, 313₂, 313₃) comblant les espaces formés par ledit profil dentelé (108) de sorte que ledit empilement présente une surface latérale sensiblement plane, lesdits bouchons (112₁, 112₂, 112₃, 113₁, 113₂, 113₃, 312₁, 312₂, 312₃, 313₁, 313₂, 313₃) étant réalisés dans un troisième matériau différent dudit premier matériau semiconducteur de sorte que chacune des faces latérales (110, 111, 310, 311) dudit bloc (104, 105, 304, 305) présente une alternance de bandes latérales (115₁, 115₂, 115₃ , 315₁, 315₂, 315₃) à base dudit premier matériau et de bandes latérales (116₁, 116₂, 116₃ , 316₁, 316₂, 316₃) à base dudit troisième matériau, au moins une des faces latérales (110, 111, 310, 311) dudit premier bloc étant revêtue partiellement d'un matériau (118, 318) favorisant la croissance de nanotubes ou de nanofils (119, 319) exclusivement sur les bandes latérales à base dudit premier matériau semiconducteur (115₁, 115₂, 115₃) ou exclusivement sur les bandes latérales à base dudit troisième matériau (316₁, 316₂, 316₃), ledit matériau favorisant la croissance de nanotubes ou de nanofils (119, 319) revêtant exclusivement les bandes latérales (115₁, 115₂, 115₃) à base dudit premier matériau semiconducteur ou exclusivement les bandes latérales à base dudit troisième matériau (316₁, 316₂, 316₃) ;
le premier et le deuxième bloc se faisant face et étant connectés par une pluralité de nanofils ou de nanotubes (119, 319) de sorte que les bandes latérales desdits deux blocs revêtues dudit matériau favorisant la croissance de nanotubes ou de nanofils sont en regard les unes des autres, chacun desdits nanofils ou desdits nanotubes (119, 319) reliant une bande latérale du premier bloc (104, 304) revêtue du matériau favorisant la croissance de nanotubes ou de nanofils à une bande latérale du deuxième bloc (105, 305) revêtue du matériau favorisant la croissance de nanotubes ou de nanofils et en regard de la bande latérale dudit premier bloc (104, 304) revêtue du matériau favorisant la croissance de nanotubes ou de nanofils.

3. Structure semiconductrice (100, 300) selon la revendication 1 ou 2 **caractérisée en ce que** ledit matériau favorisant la croissance de nanotubes ou de nanofils est un matériau catalyseur (118, 318) pour la croissance de nanotubes ou de nanofils (119, 319).

4. Structure semiconductrice (100, 300) selon l'une des revendications précédentes **caractérisée en ce que** ledit matériau favorisant la croissance de nanotubes ou de nanofils revêt partiellement lesdites bandes latérales sous forme de grains ou « nanodots » (118, 318) espacés le long desdites bandes.

5. Structure semiconductrice (100, 300) selon l'une des revendications précédentes **caractérisée en ce que** l'épaisseur desdites couches à base dudit premier matériau semiconducteur et/ou desdites couches à base dudit deuxième matériau semiconducteur est comprise entre 10 et 50 nm.

6. Structure semiconductrice (100, 300) selon l'une des revendications précédentes **caractérisé en ce que** ledit premier matériau semiconducteur est le Si et ledit deuxième matériau semiconducteur est le SiGe.

7. Structure semiconductrice (100) selon l'une des revendications précédentes **caractérisée en ce que** lesdits bouchons (112₁, 112₂, 112₃, 113₁, 113₂, 113₃) sont réalisés dans un matériau isolant, ledit matériau favorisant la croissance de nanotubes ou de nanofils revêtant exclusivement les bandes latérales (115₁, 115₂, 115₃) à base dudit premier matériau semiconducteur.

8. Structure semiconductrice (100) selon la revendication précédente **caractérisée en ce que** lesdits bouchons (112₁, 112₂, 112₃, 113₁, 113₂, 113₃) sont formés par une première partie réalisée dans un premier matériau diélectrique tel que du SiO₂ et d'une deuxième partie (114) réalisée dans un second matériau diélectrique tel qu'un nitrure de silicium du type Si₃N₄, ledit second matériau diélectrique correspondant au dit troisième matériau des bandes latérales.

9. Structure semiconductrice (300) selon l'une des revendications 1 à 6 **caractérisée en ce que** ledit troisième matériau desdits bouchons (312₁, 312₂, 312₃, 313₁, 313₂, 313₃) est un métal, ledit matériau favorisant la croissance de nanotubes ou de nanofils revêtant exclusivement les bandes latérales (316₁, 316₂, 316₃) à base dudit métal.

10. Structure semiconductrice (100, 300) selon l'une des revendications précédentes **caractérisée en ce que** ledit support (101, 301) est un substrat comportant une couche semiconductrice tel qu'un substrat du type SOI, Si ou Ge.

11. Transistor intégrant une structure selon l'une des revendications 1 à 10 **caractérisé en ce que** ladite structure est dotée d'une pluralité de nanofils ou de nanotubes formant chacun un canal de transistor.

## Patentansprüche

1. Halbleiterstruktur (100, 300), umfassend:
- einen Träger (101, 301),
- einen ersten Block (104, 304), der auf dem genannten Träger ruht, umfassend:
∘ eine Stapelung, die eine abwechselnde Folge von Schichten (106₁, 106₂, 106₃, 306₁, 306₂, 306₃) basierend auf einem ersten Halbleitermaterial und Schichten (107₁, 107₂, 107₃, 307₁, 307₂, 307₃) basierend auf einem zweiten Halbleitermaterial enthält, das von dem genannten ersten Halbleitermaterial unterschiedlich ist, wobei die genannten Schichten (106₁, 106₂, 106₃, 306₁, 306₂, 306₃) basierend auf dem genannten ersten Halbleitermaterial größere Abmessungen aufweisen als die Schichten (107₁, 107₂, 107₃, 307₁, 307₂, 307₃) basierend auf dem genannten zweiten Halbleitermaterial derart, dass die genannte Stapelung eine seitliches, gezahntes Profil (108, 308) aufweist;
∘ eine Vielzahl von Stopfen (112₁, 112₂, 112₃, 113₁, 113₂, 113₃, 312₁, 312₂, 312₃, 313₁, 313₂, 313₃), die die Räume ausfüllen, die von dem genannten gezahnten Profil (108) derart gebildet sind, dass die genannte Stapelung eine deutlich ebene seitliche Oberfläche aufweist, wobei die genannten Stopfen (112₁, 112₂, 112₃, 113₁, 113₂, 113₃, 312₁, 312₂, 312₃, 313₁, 313₂, 313₃) aus einem dritten Material hergestellt sind, das von dem ersten Halbleitermaterial derart unterschiedlich ist, dass jede der seitlichen Flächen (110, 111, 310, 311) des genannten Blocks (104, 105, 304, 305) eine abwechselnde Folge von seitlichen Bändern (115₁, 115₂, 115₃, 315₁, 315₂, 315₃) basierend auf dem genannten ersten Material und seitliche Bänder (116₁, 116₂, 116₃, 316₁, 316₂, 316₃) basierend auf dem genannten dritten Material aufweist, wobei wenigstens eine der seitlichen Flächen (110, 111, 301, 311) des genannten ersten Blocks teilweise mit einem Material (118, 318) beschichtet ist, das das Wachstum von Nanoröhrchen oder Nanodrähten (119, 319) ausschließlich auf den seitlichen Bändern basierend auf dem genannten ersten Halbleitermaterial (115₁, 115₂, 115₃) oder ausschließlich auf den seitlichen Bändern basierend auf dem genannten dritten Material (316₁, 316₂, 316₃) begünstigt, wobei das genannte Material das Wachstum von Nanoröhrchen oder Nanodrähten (119, 319) begünstigt, die ausschließlich die seitlichen Bänder (115₁, 115₂, 115₃) basierend auf dem genannten Halbleitermaterial oder ausschließlich der seitlichen Bänder basierend auf dem dritten Material (316₁, 316₂, 316₃) begünstigt;
wobei die genannte Struktur einen zweiten Block (105, 305) umfasst, der auf dem genannten Träger ruht, wobei der erste und der zweite Block einander gegenüber liegen und durch eine Vielzahl von Nanodrähten oder Nanoröhrchen (119, 319) angeschlossen sind, wobei jeder der genannten Nanodrähte oder der genannten Nanoröhrchen (119, 319) ein seitliches Band des ersten Blocks (104, 304), das mit dem Material beschichtet ist, das das Wachstum von Nanoröhrchen oder Nanodrähten begünstigt, mit einem Teil des zweiten Blocks (105, 305) verbinden, der gegenüber dem seitlichen Band des genannten ersten Blocks liegt, der mit dem Material beschichtet ist, das das Wachstum von Nanoröhrchen oder Nanodrähten begünstigt, wobei der genannte zweite Block aus einem einzigen Material gebildet ist.

2. Halbleiterstruktur (100, 300), umfassend:
- einen Träger (101, 301),
- einen ersten Block (104, 304) und einen zweiten Block (105, 305) die auf dem genannten Träger ruhen, wobei jeder des genannten ersten und zweiten Block umfasst:
∘ eine Stapelung, die eine abwechselnde Folge von Schichten (106₁, 106₂, 106₃, 306₁, 306₂, 306₃) basierend auf einem ersten Halbleitermaterial und Schichten (107₁, 107₂, 107₃, 307₁, 307₂, 307₃) basierend auf einem zweiten Halbleitermaterial enthält, das von dem genannten ersten Halbleitermaterial unterschiedlich ist, wobei die genannten Schichten (106₁, 106₂, 106₃, 306₁, 306₂, 306₃) basierend auf dem genannten ersten Halbleitermaterial größere Abmessungen aufweisen als die Schichten (107₁, 107₂, 107₃, 307₁, 307₂, 307₃) basierend auf dem genannten zweiten Halbleitermaterial derart, dass die genannte Stapelung ein seitliches, gezahntes Profil (108, 308) aufweist;
∘ eine Vielzahl von Stopfen (112₁, 112₂, 112₃, 113₁, 113₂, 113₃, 312₁, 312₂, 312₃, 313₁, 313₂, 313₃), die die Räume ausfüllen, die von dem genannten gezahnten Profil (108) derart gebildet sind, dass die genannte Stapelung eine deutlich ebene seitliche Oberfläche aufweist, wobei die genannten Stopfen (112₁, 112₂, 112₃, 113₁, 113₂, 113₃, 312₁, 312₂, 312₃, 313₁, 313₂, 313₃) aus einem dritten Material hergestellt sind, das von dem genannten ersten Halbleitermaterial derart unterschiedlich ist, dass jede der seitlichen Flächen (110, 111, 310, 311) des genannten Blocks (104, 105, 304, 305) eine abwechselnde Folge von seitlichen Bändern (115₁, 115₂, 115₃, 315₁, 315₂, 315₃) basierend auf dem genannten ersten Material und seitliche Bänder (116₁, 116₂, 116₃, 316₁, 316₂, 316₃) basierend auf dem genannten dritten Material aufweist, wobei wenigstens eine der seitlichen Flächen (110, 111, 301, 311) des genannten ersten Blocks teilweise mit einem Material (118, 318) beschichtet ist, das das Wachstum von Nanoröhrchen oder Nanodrähten (119, 319) ausschließlich auf den seitlichen Bändern basierend auf dem genannten ersten Halbleitermaterial (115₁, 115₂, 115₃) oder ausschließlich auf den seitlichen Bändern basierend auf dem genannten dritten Material (316₁, 316₂, 316₃) begünstigt, wobei das genannte Material das Wachstum von Nanoröhrchen oder Nanodrähten (119, 319) begünstigt, die ausschließlich die seitlichen Bänder (115₁, 115₂, 115₃) basierend auf dem genannten ersten Halbleitermaterial oder ausschließlich der seitlichen Bänder basierend auf dem dritten Material (316₁, 316₂, 316₃) begünstigt;
wobei der erste und der zweite Block einander gegenüber liegen und durch eine Vielzahl von Nanodrähten oder Nanoröhrchen (119, 319) derart angeschlossen sind, dass die seitlichen Bänder der genannten zweiten Blöcke, die mit dem genannten Material beschichtetet sind, das das Wachsen von Nanoröhrchen oder Nanodrähten begünstigt, einander gegenüber sind, wobei jeder der genannten Nanodrähte oder der genannten Nanoröhrchen (119, 319) ein seitliches Band des ersten Blocks (104, 304), der mit dem Material beschichtet ist, das das Wachstum von Nanoröhrchen oder Nanodrähten begünstigt, mit einem seitlichen Band des zweiten Blocks (105, 305) verbindet, der mit dem Material beschichtet ist, das das Wachstum von Nanoröhrchen oder Nanodrähten begünstigt und dem seitlichen Band des ersten Blocks (104, 304) gegenüber liegt, der mit dem Material beschichtet ist, das das Wachstum von Nanoröhrchen oder Nanodrähten begünstigt.

3. Hableiterstruktur (100, 300) gemäß Anspruch 1 oder 2, **dadurch gekennzeichnet, dass** das genannte Material, das das Wachstum von Nanoröhrchen oder Nanodrähten begünstigt, ein Katalysator (118, 318) für das Wachstum von Nanoröhrchen oder Nanodrähten (119, 319) ist.

4. Halbleiterstruktur (100, 300) gemäß einem der voranstehenden Ansprüche, **dadurch gekennzeichnet, dass** das genannte Material, das das Wachstum von Nanoröhrchen oder Nanodrähten begünstigt, teilweise die genannten seitlichen Bänder in Form von Körnern oder "Nanodots" (118, 318) abdeckt, die entlang der genannten Bänder beabstandet sind.

5. Halbleiterstruktur (100, 300) gemäß einem der voranstehenden Ansprüche, **dadurch gekennzeichnet, dass** die Dicke der genannten Schichten basierend auf dem genannten ersten Halbleitermaterial und / oder den genannten Schichten basierend auf dem genannten zweiten Halbleitermaterial zwischen 10 und 50 nm inbegriffen ist.

6. Halbleiterstruktur (100, 300) gemäß einem der voranstehenden Ansprüche, **dadurch gekennzeichnet, dass** das genannte erste Halbleitermaterial das Si ist und das genannte zweite Halbleitermaterial das SiGe ist.

7. Halbleiterstruktur (100, 300) gemäß einem der voranstehenden Ansprüche, **dadurch gekennzeichnet, dass** die genannten Stopfen (112₁, 112₂, 112₃, 113₁, 113₂, 113₃) aus einem isolierenden Material hergestellt sind, wobei das genannte Material das Wachstum von Nanoröhrchen oder Nanodrähten begünstigt, die ausschließlich die seitlichen Bänder (115₁, 115₂, 115₃) basierend auf dem genannten ersten Halbleitermaterial beschichten.

8. Halbleiterstruktur (100) gemäß dem voranstehenden Anspruch, **dadurch gekennzeichnet, dass** die genannten Stopfen (112₁, 112₂, 112₃, 113₁, 113₂, 113₃) durch einen ersten Teil, der aus einem ersten dielektrischen Material, wie z. B. SiO₂, hergestellt ist, und einem zweiten Teil (114), der aus einem zweiten dielektrischen Material, wie z. B. einem Siliziumnitrid vom Typ Si₃N₄ hergestellt ist, gebildet sind, wobei das genannte zweite dielektrische Material dem dritten Material der seitlichen Bänder entspricht.

9. Halbleiterstruktur (300) gemäß einem der Ansprüche 1 bis 6, **dadurch gekennzeichnet, dass** das genannte dritte Material der genannten Stopfen (312₁, 312₂, 312₃, 313₁, 313₂, 313₃) ein Metall ist, wobei das genannte Material das Wachstum von Nanoröhrchen oder Nanodrähten begünstigt, die ausschließlich die seitlichen Bänder (316₁, 316₂, 316₃) basierend auf dem genannten Metall beschichten.

10. Halbleiterstruktur (100, 300) gemäß einem der voranstehenden Ansprüche, **dadurch gekennzeichnet, dass** der genannte Träger (101, 301) ein Substrat ist, das eine Halbleiterschichte, wie z. B. ein Substrat vom Typ SOI, Si oder Ge, umfasst.

11. Eine Struktur gemäß einem der Ansprüche 1 bis 10 einschließender Transistor, **dadurch gekennzeichnet, dass** die genannte Struktur mit einer Vielzahl von Nanodrähten oder Nanoröhrchen dotiert ist, die jeweils einen Transistorkanal bilden.

## Claims

1. Semiconductor structure (100, 300) comprising:
- a support (101, 301);
- a first block (104, 304) resting on said support, comprising:
∘ a stack including an alternation of layers (106₁, 106₂, 106₃, 306₁, 306₂, 306₃) based on a first semiconductor material and of layers (107₁, 107₂, 107₃, 307₁, 307₂, 307₃) based on a second semiconductor material different from the first semiconductor material, said layers (106₁, 106₂, 106₃, 306₁, 306₂, 306₃) based on said first semiconductor material being larger in size than the layers (107₁, 107₂, 107₃, 307₁, 307₂, 307₃) based on said second semiconductor material in such a way that said stack has a tooth profile in the lateral direction (108, 308);
∘ a plurality of spacers (112₁, 112₂, 112₃, 113₁, 113₂, 113₃, 312₁, 312₂, 312₃, 313₁, 313₂, 313₃) filling in the spaces formed by said tooth profile (108) in such a way that said stack has a substantially flat surface in the lateral direction, said spacers (112₁, 112₂, 112₃, 113₁, 113₂, 113₃, 312₁, 312₂, 312₃, 313₁, 313₂, 313₃) being made with a third material different from said first semiconductor material in such a way that each one of the lateral faces (110, 111, 310, 311) of said block (104, 105, 304, 305) has an alternation of lateral strips (115₁, 115₂, 115₃, 315₁, 315₂, 315₃) based on said first material and of lateral strips (116₁, 116₂, 116₃, 316₁, 316₂, 316₃) based on said third material, at least one of the lateral faces (110, 111, 310, 311) of said first block being partially coated with a material (118, 318) that favours the growth of nanotubes or of nanowires (119, 319) exclusively on the lateral strips based on said first semiconductor material (115₁, 115₂, 115₃) or exclusively on the lateral strips based on said third material (316₁, 316₂, 316₃), said material that favours the growth of nanotubes or of nanowires (119, 319) coating exclusively the lateral strips (115₁, 115₂, 115₃) based on said first semiconductor material or exclusively the lateral strips based on said third material (316₁, 316₂, 316₃);
said structure comprising a second bloc (105, 305) resting on said support, the first and the second block facing each other and being connected by a plurality of nanowires or nanotubes (119, 319), each one of said nanowires or said nanotubes (119, 319) connecting a lateral strip of the first block (104, 304) coated with the material that favours the growth of nanotubes or of nanowires to a portion of the second block (105, 305) facing the lateral strip of said first block coated with the material that favours the growth of nanotubes or of nanowires,
said second block being formed from a single material.

2. Semiconductor structure (100, 300) comprising:
- a support (101, 301);
- a first block (104, 304) and a second bloc (105, 305) resting on said support, each one of said first and second blocs comprising:
∘ a stack including an alternation of layers (106₁, 106₂, 106₃, 306₁, 306₂, 306₃) based on a first semiconductor material and of layers (107₁, 107₂, 107₃, 307₁, 307₂, 307₃) based on a second semiconductor material different from the first semiconductor material, said layers (106₁, 106₂, 106₃, 306₁, 306₂, 306₃) based on said first semiconductor material being larger in size than the layers (107₁, 107₂, 107₃, 307₁, 307₂, 307₃) based on said second semiconductor material in such a way that said stack has a tooth profile in the lateral direction (108, 308);
∘ a plurality of spacers (112₁, 112₂, 112₃, 113₁, 113₂, 113₃, 312₁, 312₂, 312₃, 313₁, 313₂, 313₃) filling in the spaces formed by said tooth profile (108) in such a way that said stack has a substantially flat surface in the lateral direction, said spacers (112₁, 112₂, 112₃, 113₁, 113₂, 113₃, 312₁, 312₂, 312₃, 313₁, 313₂, 313₃) being made with a third material different from said first semiconductor material in such a way that each one of the lateral faces (110, 111, 310, 311) of said block (104, 105, 304, 305) has an alternation of lateral strips (115₁, 115₂, 115₃, 315₁, 315₂, 315₃) based on said first material and of lateral strips (116₁, 116₂, 116₃, 316₁, 316₂, 316₃) based on said third material, at least one of the lateral faces (110, 111, 310, 311) of said first block being partially coated with a material (118, 318) that favours the growth of nanotubes or of nanowires (119, 319) exclusively on the lateral strips based on said first semiconductor material (115₁, 115₂, 115₃) or exclusively on the lateral strips based on said third material (316₁, 316₂, 316₃), said material that favours the growth of nanotubes or of nanowires (119, 319) coating exclusively the lateral strips (115₁, 115₂, 115₃) based on said first semiconductor material or exclusively the lateral strips based on said third material (316₁, 316₂, 316₃);
the first and the second block are facing each other and are connected by a plurality of nanowires or nanotubes (119, 319) in such a way that the lateral strips of said two blocks coated with said material that favours the growth of nanotubes or of nanowires are facing each other, each one of said nanowires or said nanotubes (119, 319) connecting a lateral strip of the first block (104, 304) coated with the material that favours the growth of nanotubes or of nanowires to a lateral strip of the second block (105, 305) coated with the material that favours the growth of nanotubes or of nanowires and facing the lateral strip of said first block (104, 304) coated with the material that favours the growth of nanotubes or of nanowires.

3. Semiconductor structure (100, 300) according to claim 1 or 2 **characterised in that** said material that favours the growth of nanotubes or of nanowires is a catalyst material (118, 318) for the growth of nanotubes or of nanowires (119, 319).

4. Semiconductor structure (100, 300) according to one of the preceding claims **characterised in that** said material that favours the growth of nanotubes or of nanowires partially coats said lateral strips in the form of grains or "nanodots" (118, 318) spaced along said strips.

5. Semiconductor structure (100, 300) according to one of the preceding claims **characterised in that** the thickness of said layers based on said first semiconductor material and/or of said layers based on said second semiconductor material is between 10 and 50 nm.

6. Semiconductor structure (100, 300) according to one of the preceding claims **characterised in that** said first semiconductor material is Si and said second semiconductor material is SiGe.

7. Semiconductor structure (100) according to one of the preceding claims **characterised in that** said spacers (112₁, 112₂, 112₃, 113₁, 113₂, 113₃) are made from an insulating material, said material that favours the growth of nanotubes or of nanowires coating exclusively the lateral strips (115₁, 115₂, 115₃) based on said first semiconductor material.

8. Semiconductor structure (100) according to the preceding claim **characterised in that** said spacers (1124, 1122, 112a, 1131, 1132, 113) are formed by a first portion made in a first dielectric material such as SiO₂ and by a second portion (114) made in a second dielectric material such as a silicon nitride of the Si₃N₄ type, said second dielectric material corresponding to said third material of the lateral strips.

9. Semiconductor structure (300) according to one of claims 1 to 6 **characterised in that** said third material of said spacers (312₁, 312₂, 312₃, 313₁, 313₂, 313₃) is a metal, said material that favours the growth of nanotubes or of nanowires coating exclusively the lateral strips (316₁, 316₂, 316₃) based on said metal.

10. Semiconductor structure (100, 300) according to one of the preceding claims **characterised in that** said support (101, 301) is a substrate comprising a semiconductor layer such as a substrate of the SOI, Si or Ge type.

11. Transistor integrating a structure according to one of claims 1 to 10 **characterised in that** said structure is provided with a plurality of nanowires or nanotubes each forming a transistor channel.
